# EUROPEAN PATENT SPECIFICATION

(11) **EP 3 219 760 B1**
(45) Date of publication and mention of the grant of the patent: **09.10.2019**
(21) Application number: 14905775.4
(22) Date of filing: 02.12.2014
(51) Int. Cl.: C08L 79/04, C08L 63/00, C08L 35/06, C08L 71/12, B32B 15/08, B32B 15/092, B32B 27/04, H05K 1/03, C08G 59/42

(54) **THERMOSET RESIN COMPOSITION, AND PREPREG AND LAMINATED BOARD MADE OF SAME**
WÄRMEHÄRTENDE HARZZUSAMMENSETZUNG UND PREPREG SOWIE DARAUS HERGESTELLTE LAMINIERTE PLATTE
COMPOSITION DE RÉSINE THERMODURCISSABLE, PRÉ-IMPRÉGNÉ ET CARTE STRATIFIÉE À BASE DE CELLE-CI

(30) Priority: 11.11.2014 CN 201410633139
(43) Date of publication of application: 20.09.2017
(73) Proprietor: Shengyi Technology Co., Ltd., Dongguan City, Guangdong 523808 (CN)
(72) Inventor: FANG, Kehong, Dongguan Guangdong 523808 (CN); LI, Hui, Dongguan Guangdong 523808 (CN)
(74) Representative: Krauns, Christian
(86) International application number: PCT/CN2014/092840
(87) International publication number: WO 2016/074289

(56) References cited:
- EP-B1- 2 194 098
- CN-A- 102 181 143
- CN-A- 102 585 480
- CN-A- 103 013 110
- US-A1- 2013 075 138
- DATABASE CAPLUS [Online] CHEMICAL ABSTRACTS SERVICE, COLUMBUS, OHIO, US; 1988, Aliev S.M. et al: "Crosslinking of epoxy resins with oligomers of allylaromatic compounds with maleic anhydrides", XP002779893, Database accession no. 1988:6291
- HA NGUYEN T HIEU ED - BALLAUFF MATTHIAS ET AL: "Determination of triad sequence distribution of copolymers of maleic anhydride and its derivates with donor monomers by13C n.m.r. spectroscopy", POLYMER, vol. 40, no. 4, 14 April 1998 (1998-04-14) , pages 1081-1086, XP029989638, ISSN: 0032-3861, DOI: 10.1016/S0032-3861(98)00313-9

## Description

### Technical field

The present invention relates to the technical field of laminates, specifically involves a resin composition, especially a thermosetting resin composition and a prepreg, a laminate and a printed circuit board prepared therefrom.

### Background art

With the rapid development of the electronics industry, electronic products tend to be light, thin, short, high density, security and high functionality, requiring electronic components to have higher signal transmission speed and transmission efficiency, which makes higher performance requirements on the printed circuit board as the carrier. Due to high speed and multi-functionalization of electronic product information processing, the application frequency is continually increased, and 3GHz or more will gradually become mainstream, therefore, besides maintaining the higher requirements on heat resistance of laminate materials, dielectric constant and dielectric loss value will be required to be lower and lower.

The current traditional FR-4 is difficult to meet the application demand on high frequency and rapid development of electronic products. Meanwhile, the substrate material no longer plays the traditional mechanical support role, and will become together with the electronic components an important way to improve product performances for PCB and designers of terminal manufacturers.

Because high Dk will slow down the signal transmission rate, and high Df will convert the signal partly into heat loss in the substrate material, high-frequency transmission with low dielectric constant and low dielectric loss, especially the development of halogen-free high-frequency plates, has become the focus of copper clad laminate industry.

At present, halogen-containing flame retardants (especially brominated flame retardants) are widely used in polymer flame retardant materials, and play a better flame retardant effect. However, it is concluded after the in-depth study of the fire scene that, although the halogen-containing flame retardant has a better flame retardant effect and a small addition amount, the polymer material containing the halogen-containing flame retardant will produce a lot of toxic and corrosive gas and smoke which suffocate people, thereby being more harmful than the fire itself. As a result, the development of the halogen-free flame retardant printed circuit boards has become a key point in the industry with the formal implementations of the EU Waste Electrical and Electronic Equipment Directive and the Restriction of the Use of Certain Hazardous Substances in Electrical and Electronic Equipment on July 1, 2006. The CCL manufacturers have launched their own halogen-free flame retardant copper clad laminate.

In order to solve the above-mentioned problems, CN101796132B discloses a composition comprising an epoxy resin, a low molecular weight phenol-modified polyphenylene ether and a cyanate. Such epoxy resin composition has excellent dielectric properties, and is capable of maintaining flame retardancy and has high heat resistance. However, brominated flame retardant is used in the epoxy composition for flame retardancy. Although such composition has excellent comprehensive performance, the flame retardant containing bromine component are easy to cause environmental pollution during the product manufacture, use or even recovery or disposal, and are hard to meet the requirements of the environmental protection.

CN103013110A discloses a cured product comprising a cyanate, allyl benzene-maleic anhydride, a polyphenylene ether, and bismaleimide, and the use of phosphorus-nitrogen compound as flame retardant can achieve low dielectric constant, low dielectric loss, high heat resistance and high flame resistance. However, bismaleimide has a high curing temperature, and the cured product is more brittle, resulting in many deficiencies during the processing and use US-A-2013/0115472 discloses halogen-free resin compositions for copper clad laminates and circuit boards containing cyanate ester , styrene-maleic anhydride copolymers and polyphenylene oxide as components.

Therefore, it is an urgent problem to be solved how to produce a prepreg and laminate having low dielectric constant, low dielectric loss and excellent chemical resistance.

### Disclosure of the invention

The present invention aims to provide a resin composition, especially a thermosetting resin composition and a prepreg, a laminate and a printed circuit board prepared therefrom.

In order to achieve the object, the present invention uses the following technical solution.

On one aspect, the present invention provides a thermosetting resin composition consisting of the following components in parts by weight: 50-150 parts of a cyanate, 30-120 parts of an epoxy resin, 20-70 parts of allyl benzene-maleic anhydride, 20-100 parts of a polyphenyl ether, 30-100 parts of a halogen-free flame retardant, 0.05-5 parts of a curing accelerator, and 50-200 parts of a filler.

The allyl benzene-maleic anhydride of the present invention has the following chemical structural formula: 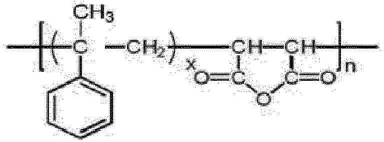 wherein x is 1-4, 6 and 8; n is 1-12; x and n are both integers.

In the present invention, the allyl benzene-maleic anhydride is in an amount of 20-70 parts by weight, e.g. 20, 25, 30, 35, 40, 45, 50, 55, 60, 65, and 70 parts by weight.

The present invention adopts allyl benzene-maleic anhydride, which not only makes the substrate have low dielectric constant and dielectric loss, but also increases the heat resistance of the substrate because of the increase of the steric hindrance and the rotational steric hindrance in the molecular chain due to the presence of methyl group. Meanwhile, the hydrophobicity of methyl group can remarkably improve the moisture resistance of the substrate.

The cyanate in the present invention is at least one selected from the group consisting of the following chemical structures: 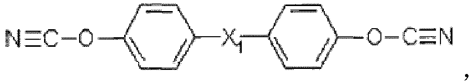 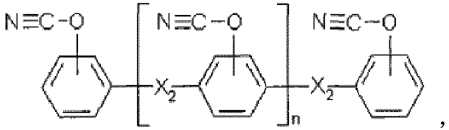 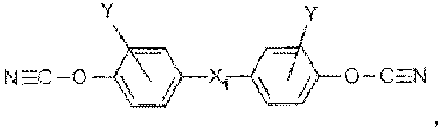 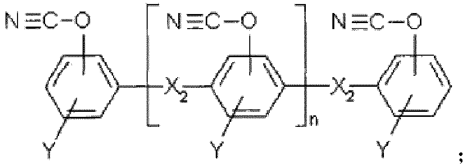 wherein X₁ and X₂ are each independently selected from at least one of R, Ar, SO₂ and O; R is selected from the group consisting of -C(CH₃)₂-, -CH(CH₃)-, -CH₂- and substituted or unsubstituted dicyclopentadienyl; Ar is anyone selected from the group consisting of substituted or unsubstituted benzene, biphenyl, naphthalene, phenolic aldehyde, bisphenol A, bisphenol A phenolic aldehyde, bisphenol F and bisphenol F phenolic aldehyde; n is an integer of greater than or equal to 1; Y is an aliphatic functional group or aromatic functional group.

In the present invention, said cyanate is in an amount of 50-150 parts by weight, e.g. 50, 60, 65, 70, 75, 80, 85, 90, 95, 100, 105, 110, 115, 120, 125, 130, 135, 140, 145, or 150 parts by weight.

By adding cyanate, the thermosetting resin composition of the present invention can notably increase the heat resistance and dielectric properties of the system.

The epoxy resin of the present invention is anyone selected from the group consisting of bisphenol A type epoxy resin, bisphenol F type epoxy resin, bisphenol AD type epoxy resin, bisphenol Z type epoxy resin, bisphenol M type epoxy resin, bisphenol AP type epoxy resin, bisphenol TMC type epoxy resin, biphenyl epoxy resin, alkyl novolac epoxy resin, dicyclopentadiene epoxy resin, bisphenol A type novolac epoxy resin, o-cresol type novolac epoxy resin, phenol type novolac epoxy resin, trifunctional epoxy resin, tetrafunctional epoxy resin, isocyanate modified epoxy resin and naphthalene type epoxy resin, or a mixture of at least two selected therefrom.

In the present invention, the epoxy resin is in an amount of 30-120 parts by weight, e.g. 30, 35, 40, 45, 50, 55, 60, 65, 70, 75, 80, 85, 90, 95, 100, 110, 120 parts by weight.

Due to the introduction of the epoxy resin, the thermosetting resin composition of the present invention can greatly improve the processability.

In the present invention, said polyphenyl ether has a low molecular weight and has a number-average molecular weight of 1000-4000.

In the present invention, said polyphenyl ether is in an amount of 20-100 parts by weight, e.g. 20, 25, 30, 35, 40, 45, 50, 55, 60, 65, 70, 75, 80, 85, 90, 95, or 100 parts by weight.

By adding polyphenylene ether, the thermosetting resin composition of the present invention can greatly reduce the dielectric constant and dielectric loss of the plate. In addition, the use of polyphenylene ether can improve the toughness of the plate and have positive influence on the use of the plate in the high-frequency multilayer circuit board.

The halogen-free flame retardant of the present invention is anyone selected from the group consisting of phosphazene, ammonium polyphosphate, tri-(2-carboxyethyl)-phosphine, tri-(isopropylchloro)phosphate, trimethyl phosphate, dimethyl-methyl phosphate, resorcinol bis-xylyl phosphate, phosphorus-nitrogen compounds, melamine polyphosphate, melamine cyanurate, tri-hydroxyethyl isocyanurate, 9,10-dihydro-9-oxa-10-phosphaphenanthrene-10-oxide and DOPO-containing novolac resin, or a mixture of at least two selected therefrom.

In the present invention, said halogen-free flame retardant is in an amount of 30-100 parts by weight, e.g. 30, 35, 40, 45, 50, 60, 70, 80, 90, or 100 parts by weight.

The curing accelerator of the present invention is anyone selected from the group consisting of imidazoles, metal salts, tertiary amines or piperidine compounds, or a mixture of at least two selected therefrom.

Preferably, said curing accelerator is anyone selected from the group consisting of 2-methylimidazole, undecyl imidazole, 2-ethyl-4-methylimidazole, 2-phenyl-imidazole, 1-cyanoethyl substituted imidazole, benzyldimethylamine, cobalt acetylacetonate, copper acetylacetonate and zinc isooctanoate, or a mixture of at least two selected therefrom.

In the present invention, said curing accelerator is in an amount of 0.05-5 parts by weight, e.g. 0.05, 1, 1.5, 2, 2.5, 3, 3.5, 4, 4.5, or 5 parts by weight.

Preferably, said filler is an inorganic or organic filler.

Preferably, said filler is an inorganic filler, which is anyone selected from the group consisting of aluminum hydroxide, alumina, magnesium hydroxide, magnesium oxide, aluminum oxide, silicon dioxide, calcium carbonate, aluminum nitride, boron nitride, silicon carbide, titanium dioxide, zinc oxide, zirconium oxide, mica, boehmite, calcined talc, talc powder, silicon nitride and calcined kaolin, or a mixture of at least two selected therefrom.

Preferably, said filler is an organic filler, which is anyone selected from the group consisting of polytetrafluoroethylene powder, polyphenylene sulfide and polyethersulfone powder, or a mixture of at least two selected therefrom.

Preferably, said filler has a particle size of 0.01-50µm, e.g. 0.01µm, 0.05µm, 1µm, 5µm, 10µm, 15µm, 20µm, 25µm, 30µm, 40µm, 50µm, preferably 1-15µm, further preferably 1-5µm.

In order to homogeneously disperse the filler in the resin composition of the present invention, a dispersant may be added in the form of an aminosilane coupling agent or an epoxy silane coupling agent to improve the binding performance between inorganic and woven glass cloth, so as to achieve the purpose of homogeneous dispersion. Moreover, such coupling agent contains no heavy metal, and will not have adverse effects on human bodies. Such coupling agent is in an amount of 0.5-2 wt.% of the inorganic filler. If the amount thereof is too high, it will speed up the reaction and affect the storage time. If the amount thereof is too small, there is no significant effect on the improvement of the bonding stability.

On the second aspect, the present invention provides a prepreg prepared from the thermosetting resin composition as stated in the first aspect of the present invention, wherein said prepreg comprises a matrix material, and the thermosetting resin composition attached thereon after impregnation and drying.

The matrix material of the present invention is a non-woven or woven glass fiber cloth.

On the third aspect, the present invention further provides a laminate comprising the prepreg as stated in the second aspect of the present invention.

On the fourth aspect, the present invention further provides a printed circuit board comprising the laminate as stated in the third aspect of the present invention.

As compared to the prior art, the present invention has the following beneficial effects.

The prepreg and the laminate prepared from the thermosetting resin composition of the present invention have a low dielectric constant which can be controlled below 3.6 and a low dielectric loss which is between 0.0040 and 0.0046, and have excellent flame retardancy, heat resistance, moisture resistance and other comprehensive properties. The flame retardancy thereof can reach the V-0 standard in the flame retardant test UL-94, and the PCT water absorption thereof is 0.29-0.32. They are suitable for the use in halogen-free high-frequency multi-layer circuit boards.

### Embodiments

The technical solution of the present invention will be further described below by the specific embodiments.

Those skilled in the art shall know that the examples are merely illustrative of the present invention and should not be construed as specifically limiting the present invention.

### Preparation Example: Synthesis of allyl benzene-maleic anhydride

Under the conditions of nitrogen protection and stirring, a maleic anhydride monomer and an initiator were added and dissolved in a medium and heated to 60-80°C. An allyl benzene monomer and a molecular weight regulator were added dropwise. After adding dropwise, the stirring continued for 1-8h to obtain a dispersion system of low molecular weight allyl benzene/maleic anhydride polymer particles, and the dispersion system was centrifuged and dried to obtain a low molecular weight allyl benzene/maleic anhydride alternating copolymer, wherein said initiator was an organic peroxide or azo compound; said medium was a mixed solution of an organic acid alkyl ester and an alkane; said molecular weight regulator was vinyl acetate; maleic anhydride and allyl benzene were in a molar ratio of 1:0.90-0.96; the sum of the mass concentration of two kinds of monomers in the reaction system, maleic anhydride and allyl benzene, was 2.0-7.5%. The mass concentration of the initiator in the reaction system was 0.05-0.35%; the mass concentration of the molecular weight regulator in the reaction system was 0.10-0.45%; the volume fraction of the organic acid alkyl ester in the mixed solution of the organic acid alkyl ester and alkane was 20 -80%.

Allyl benzene-maleic anhydride having the following chemical structural formula is obtained: 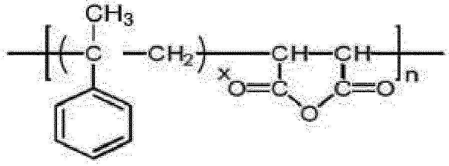 wherein x is 1-4, 6 and 8; n is 1-12; x and n are both integers.

### Examples: Process for preparing copper clad laminates

A cyanate, an epoxy resin, allyl benzene-maleic anhydride, a polyphenylene ether, a halogen-free flame retardant, a curing accelerator, a filler and a solvent were put into a container and stirred to make the mixture uniformly into a glue. The solid content of the solution was adjusted to 60%-70% with the solvent to obtain a glue solution, i.e. a thermosetting resin composition glue solution. A 2116 electronic grade glass cloth was impregnated with the glue, baked into a prepreg by an oven. 6 pieces of 2116 prepregs were covered with electrolytic copper foils having a thickness of 35 µm on both sides, vacuum-laminated in a hot press, cured at 190°C for 120min to obtain copper clad laminates.

The components and contents thereof (based on parts by weight) in Examples 1-6 and Comparison Examples 1-5 are shown in Table 1. The component codes and the corresponding component names are shown as follows.
(A) Cyanate: HF-10(Product name from Shanghai Hui Feng trading)
(B) Epoxy resin
(B-1) Biphenyl epoxy resin: NC-3000-H (Product name from Nippon Kayaku);
(B-2) Dicyclopentadiene epoxy resin: HP-7200H (Product name from Dainippon Ink and Chemicals)
(C-1) Allyl benzene-maleic anhydride synthesized in the preparation example;
(C-2) Styrene-maleic anhydride oligomer: SMA-EF40 (Product name from Sartomer);
(D-1) Polyphenyl ether having a low molecular weight: MX90 (Product name from SABIC Innovative Plastics) having a number-average molecular weight of 1000-4000;
(D-2) Polyphenyl ether having a high molecular weight: Sabic640-111(Product name from SABIC Innovative Plastics) having a number-average molecular weight of 15000-20000;
(E) Halogen-free flame retardant;
(E-1) PX-200 (Product name from Daihachi Chemical Industry Co.);
(E-2) SPB-100 (Product name from Otsuka Chemical Co.);
(G) Curing accelerator;
(H) Filler: molten silica.

The processes for preparing CCLs in Examples 1-6 and Comparison Examples 1-5 are the same as those in the examples.

The glass transition temperature (Tg), peeling strength (PS), dielectric constant (Dk) and dielectric loss angle tangent (Tg), flame retardancy, dip soldering resistance and water absorption after PCT 2h of the copper clad laminates prepared in Examples 1-6 and Comparison Examples 1-5 were tested by the following methods, and the test results are shown in Table 2.

The performance parameters are tested by the following methods.
A Glass transition temperature (Tg): tested according to the DSC method as stipulated under IPC-TM-650 2.4.25 in accordance with DSC;
B Peeling strength (PS): testing the peeling strength of the metal cover layer under the testing conditions of "after thermal stress" in the method of IPC-TM-650 2.4.8;
C Dielectric constant (Dk) and dielectric loss angle tangent (Df): testing dielectric constant (Dk) and dielectric loss angle tangent (Df) under 1GHz by the resonance method using a stripe line according to IPC-TM-650 2.5.5.5;
D Flame retardancy: tested according to the UL-94 standard;
E Dip soldering resistance and water absorption after PCT 2h:

The copper clad laminate was immersed in a copper etching solution to remove the surface copper foils, and to evaluate the substrate. The substrate was placed in a pressure cooker and treated at 121°C and 2 atm for 2 hours. After the water absorption was measured, the substrate was immersed in a tin furnace having a temperature of 288°C. The corresponding time was recorded when the substrate is bubbled or split. The evaluation was finished when the substrate had no foaming or stratification in the tin furnace for more than 5 min.

**Table 1**

| | Example 1 | Example 2 | Example 3 | Example 4 | Example 5 | Example 6 | Comparison Example 1 | Comparison Example 2 | Comparison Example 3 | Comparison Example 4 | Comparison Example 5 |
|---|---|---|---|---|---|---|---|---|---|---|---|
| A | 100 | 100 | 100 | 100 | 50 | 150 | 100 | 100 | 100 | 100 | 100 |
| B-1 | 80 | 80 | 80 | 40 | 30 | 60 | 80 | 80 | 40 | 80 | 80 |
| B-2 | | | | 40 | | 60 | | | 40 | | |
| C-1 | 25 | 35 | 60 | 35 | 20 | 70 | | | 5 | 60 | 60 |
| C-2 | | | | | | | 25 | 60 | | | |
| D-1 | 50 | 50 | 50 | 50 | 20 | 100 | 50 | 50 | 50 | | |
| D-2 | | | | | | | | | | | 50 |
| E-1 | 20 | 20 | 20 | 20 | | 42 | 20 | 20 | 20 | 20 | 20 |
| E-2 | 45 | 45 | 45 | 45 | 30 | 58 | 45 | 45 | 45 | 45 | 45 |
| G | q.s | q.s | q.s | q.s | q.s | q.s | q.s | q.s | q.s | q.s | q.s |
| H | 110 | 110 | 110 | 110 | 50 | 200 | 110 | 110 | 110 | 110 | 110 |

**Table 2**

| Test items | Example 1 | Example 2 | Example 3 | Example 4 | Example 5 | Example 6 | Comparison Example 1 | Comparison Example 2 | Comparison Example 3 | Comparison Example 4 | Comparison Example 5 |
|---|---|---|---|---|---|---|---|---|---|---|---|
| Tg(DSC) (°C) | 185 | 190 | 197 | 191 | 191 | 194 | 171 | 180 | 170 | 198 | 195 |
| Peeling strength (N/mm) | 1.48 | 1.43 | 1.42 | 1.41 | 1.43 | 1.42 | 1.50 | 144 | 1.55 | 1.42 | 1.41 |
| Dielectric constant(1GHz) | 3.6 | 3.6 | 3.5 | 3.6 | 3.6 | 3.5 | 3.8 | 3.8 | 3.9 | 4.0 | 3.6 |
| Dielectric loss (1GHz) | 0.0046 | 0.0042 | 0.0040 | 0.0042 | 0.0042 | 0.0040 | 0.0048 | 0.0045 | 0.0058 | 0.0080 | 0.0042 |
| Combustibility | V-0 | V-0 | V-0 | V-0 | V-0 | V-0 | V-0 | V-0 | V-0 | V-0 | V-0 |
| PCT(min) | >5 | >5 | >5 | >5 | >5 | >5 | >5 | >5 | 3 | 3 | >5 |
| PCT water absorption | 0.32 | 0.30 | 0.29 | 0.29 | 0.30 | 0.30 | 0.34 | 0.32 | 0.30 | 0.32 | 0.29 |
| Processability | Better | Better | Better | Better | Better | Better | Better | Better | Better | Better | Worse |

It can be seen according to the data in Tables 1 and 2 that,
(1) As can be seen from Examples 1 to 3, the glass transition temperature of the substrate could be remarkably improved, and the dielectric properties and the PCT water absorption rate could also be improved, along with the increase of the amount of allyl benzene-maleic anhydride in Examples 1-3; by comparing Examples 1 and 3 with Comparison Examples 1-2, it could be found that the dielectric properties and the PCT water absorption of Examples 1 and 3 were significantly lower than those of Comparison Examples 1-2, which showed that the addition of allyl benzene-maleic anhydride of the present invention in Examples 1 and 3 improved the dielectric properties and PCT water absorption and increased the glass transition temperature of the substrate as compared to using styrene-maleic anhydride in Comparison Examples 1-2;
(2) As can be seen from Examples 4-6 and Comparison Example 3, the components to be used were controlled within certain weight ranges, so that the substrates had excellent overall properties; by comparing Comparison Example 3 with Example 4, it could be found that, when the amount of allyl benzene-maleic anhydride was reduced to 5 parts by weight, the dielectric properties of the substrate were significantly deteriorated; the glass transition temperature was significantly reduced, and it could not pass the 2-hour PCT test;
(3) As can be seen from Example 3 and Comparison Example 4, the dielectric constant, dielectric loss and PCT water absorption of Example 3 were lower than those of Comparison Example 4, and Comparison Example 4 could not pass the 2h PCT test; it was found that the dielectric properties in Example 3 was remarkably improved after adding a polyphenyl ether having a low molecular weight as compared to Comparison Example 4 in which a polyphenyl ether having a low molecular weight was not added; moreover, Example 3 could pass the 2h PCT test; by comparing Example 3 with Comparison Example 5, it can be found that, although their overall properties were equivalent, the use of a polyphenylene ether having a high molecular weight resulted in poor processability.

According to Examples 1 to 6, it was found that the laminates prepared by using the thermosetting resin composition of the present invention have a dielectric constant of 3.6 or less, a dielectric loss of 0.0040 to 0.0046, and have excellent flame retardancy, heat resistance, moisture resistance and other comprehensive performances. The flame retardancy thereof can reach the V-0 standard in the flame retardant test UL-94, and PCT water absorption is 0.29-0.32. Thus they are suitable for use in halogen-free high-frequency multilayer circuit boards.

In summary, the thermosetting resin composition of the present invention has a low dielectric constant, low dielectric loss, excellent heat resistance and cohesiveness while ensuring halogen-free flame retardancy, and is suitable for use in halogen-free high frequency multilayer circuit boards.

Certainly, the above-described examples are merely illustrative examples of the present invention and are not intended to limit the implement scope of the present invention. Therefore any equivalent changes or modifications according to the principles within the patent scope of the present invention are all included in the scope of the present patent.

## Claims

1. A thermosetting resin composition consisting of the following components in parts by weight: 50-150 parts of a cyanate, 30-120 parts of an epoxy resin, 20-70 parts of allyl benzene-maleic anhydride, 20-100 parts of a polyphenyl ether, 30-100 parts of a halogen-free flame retardant, 0.05-5 parts of a curing accelerator, and 50-200 parts of a filler;
the allyl benzene-maleic anhydride has the following chemical structural formula: 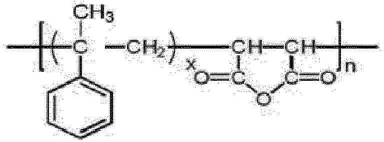 wherein x is 1-4, 6 and 8; n is 1-12; x and n are both integers.

2. The thermosetting resin composition claimed in claim 1, **characterized in that** the cyanate is at least one selected from the group consisting of the following 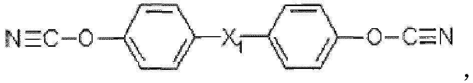 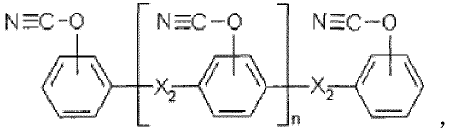 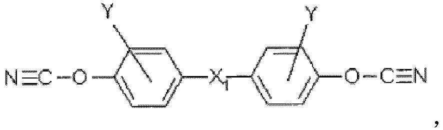 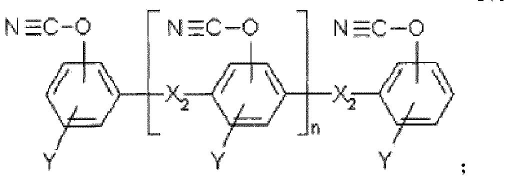 wherein X₁ and X₂ are each independently selected from at least one of R, Ar, SO₂ and O; R is selected from the group consisting of -C(CH₃)₂-, -CH(CH₃)-, -CH₂- and substituted or unsubstituted dicyclopentadienyl; Ar is anyone selected from the group consisting of substituted or unsubstituted benzene, biphenyl, naphthalene, phenolic aldehyde, bisphenol A, bisphenol A phenolic aldehyde, bisphenol F and bisphenol F phenolic aldehyde; n is an integer of greater than or equal to 1; Y is an aliphatic functional group or aromatic functional group.

3. The thermosetting resin composition claimed in claim 1, **characterized in that** the epoxy resin is anyone selected from the group consisting of bisphenol A type epoxy resin, bisphenol F type epoxy resin, bisphenol AD type epoxy resin, bisphenol Z type epoxy resin, bisphenol M type epoxy resin, bisphenol AP type epoxy resin, bisphenol TMC type epoxy resin, biphenyl epoxy resin, alkyl novolac epoxy resin, dicyclopentadiene epoxy resin, bisphenol A type novolac epoxy resin, o-cresol type novolac epoxy resin, phenol type novolac epoxy resin, trifunctional epoxy resin, tetrafunctional epoxy resin, isocyanate modified epoxy resin and naphthalene type epoxy resin, or a mixture of at least two selected therefrom.

4. The thermosetting resin composition claimed in claim 1, **characterized in that** the halogen-free flame retardant is anyone selected from the group consisting of phosphazene, ammonium polyphosphate, tri-(2-carboxyethyl)phosphine, tri-(isopropylchloro)phosphate, trimethyl phosphate, dimethyl-methyl phosphate, resorcinol bis-xylyl phosphate, phosphorus-nitrogen compounds, melamine polyphosphate, melamine cyanurate, tri-hydroxyethyl isocyanurate, 9,10-dihydro-9-oxa-10-phosphaphenanthrene-10-oxide and DOPO-containing novolac resin, or a mixture of at least two selected therefrom.

5. The thermosetting resin composition claimed in claim 1, **characterized in that** the curing accelerator is anyone selected from the group consisting of imidazole, metal salts, tertiary amines or piperidine compounds, or a mixture of at least two selected therefrom;
preferably, the curing accelerator is anyone selected from the group consisting of 2-methylimidazole, undecyl imidazole, 2-ethyl-4-methylimidazole, 2-phenyl-imidazole, 1-cyanoethyl substituted imidazole, benzyldimethylamine, cobalt acetylacetonate, copper acetylacetonate and zinc isooctanoate, or a mixture of at least two selected therefrom.

6. The thermosetting resin composition claimed in claim 1, **characterized in that** the filler is an inorganic or organic filler;
preferably, the filler is an inorganic filler, which is anyone selected from the group consisting of aluminum hydroxide, alumina, magnesium hydroxide, magnesium oxide, aluminum oxide, silicon dioxide, calcium carbonate, aluminum nitride, boron nitride, silicon carbide, titanium dioxide, zinc oxide, zirconium oxide, mica, boehmite, calcined talc, talc powder, silicon nitride and calcined kaolin, or a mixture of at least two selected therefrom;
preferably, the filler is an organic filler, which is anyone selected from the group consisting of polytetrafluoroethylene powder, polyphenylene sulfide and polyethersulfone powder, or a mixture of at least two selected therefrom;

7. A prepreg prepared from the thermosetting resin composition claimed in any of claims 1-6, **characterized in that** the prepreg comprises a matrix material, and the thermosetting resin composition attached thereon after impregnation and drying; preferably, the matrix material is a non-woven or woven glass fiber cloth.

8. A laminate comprising the prepreg claimed in claim 7.

9. A printed circuit board comprising the laminate claimed in claim 8.

## Patentansprüche

1. Wärmehärtbare Harzzusammensetzung, die aus den folgenden Komponenten in Gewichtsteilen besteht: 50 bis 150 Teile eines Cyanats, 30 bis 120 Teile eines Epoxyharzes, 20 bis 70 Teile eines Allylbenzolmaleinsäureanhydrid, 20 bis 100 Teile eines Polyphenylethers, 30 bis 100 Teile eines halogenfreien Flammschutzmittels, 0,05 bis 5 Teile eines Härtungsbeschleunigers und 50 bis 200 Teile eines Füllstoffs,
wobei das Allylbenzol-Maleinsäureanhydrid die folgende chemische Strukturformel aufweist: 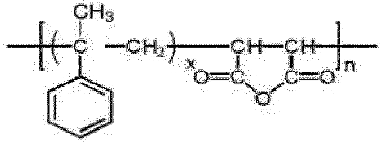 wobei das x 1 bis 4, 6 und 8 ist, das n 1 bis 12 ist, und das x und das n beide ganze Zahlen sind.

2. Wärmehärtbare Harzzusammensetzung nach Anspruch 1, **dadurch gekennzeichnet, dass** das Cyanat mindestens eines ist, das aus der Gruppe ausgewählt worden ist, die aus dem Folgendem besteht 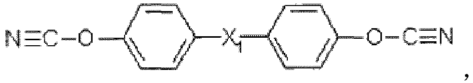 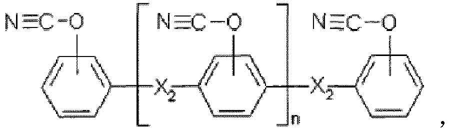 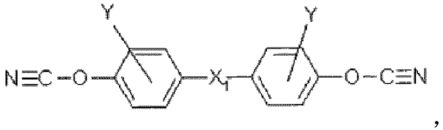 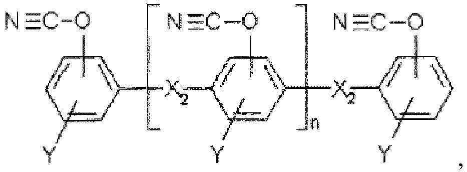 wobei das X₁ und das X₂ jeweils unabhängig voneinander aus einem R, einem Ar, einem SO₂ und / oder einem O ausgewählt worden sind, wobei das R aus der Gruppe ausgewählt worden ist, die ein -C(CH₃)₂-, ein -CH(CH₃)-, ein -CH₂- und ein substituiertes oder ein unsubstituiertes Dicyclopentadienyl umfasst, wobei das Ar ein beliebiges ist, das aus der Gruppe ausgewählt worden ist, die ein substituiertes oder ein unsubstituiertes Benzol, ein Biphenyl, ein Naphthalin, ein Phenolaldehyd, ein Bisphenol A, ein Bisphenol A Phenolaldehyd, ein Bisphenol F und ein Bisphenol F Phenolaldehyd umfasst, wobei das n eine ganze Zahl größer als oder gleich 1 ist, wobei das Y eine aliphatische funktionelle Gruppe oder eine aromatische funktionelle Gruppe ist.

3. Wärmehärtbare Harzzusammensetzung nach Anspruch 1, **dadurch gekennzeichnet, dass** das Epoxidharz ein beliebiges ist, das aus der Gruppe ausgewählt worden ist, die ein Epoxidharz vom Typ Bisphenol A, ein Epoxidharz vom Typ Bisphenol F, ein Epoxidharz vom Typ Bisphenol AD, ein Epoxidharz vom Typ Bisphenol Z und ein Epoxidharz vom Typ Bisphenol M, ein Epoxidharz vom Typ Bisphenol AP, ein Epoxidharz vom Typ Bisphenol TMC, ein Biphenyl-Epoxidharz, ein Alkylnovolak-Epoxidharz, ein Dicyclopentadien-Epoxidharz, ein Novolak-Epoxidharz vom Typ Bisphenol A, ein Novolak-Epoxidharz vom Typ o-Cresol, ein Novolak-Epoxidharz vom Typ Phenol, ein trifunktionelles Epoxidharz, ein tetrafunktionelles Epoxidharz, ein mit Isocyanat modifiziertes Epoxidharz und ein Epoxidharz vom Typ Naphthalin oder eine Mischung von mindestens zwei davon umfasst.

4. Wärmehärtbare Harzzusammensetzung nach Anspruch 1, **dadurch gekennzeichnet, dass** das halogenfreie Flammschutzmittel ein beliebiges ist, das aus der Gruppe ausgewählt worden ist, die ein Phosphazen, ein Ammoniumpolyphosphat, ein Tri-(2-Carboxyethyl)Phosphin, ein Tri-(lsopropylchlor)Phosphat, ein Trimethylphosphat, ein Dimethylmethylphosphat, ein Resorcin-Bis-Xylylphosphat, Phosphor-Stickstoff-Verbindungen, ein Melaminpolyphosphat, ein Melamincyanurat, ein Trihydroxyethylisocyanurat, ein 9,10-Dihydro-9-Oxa-10-Phosphaphenanthren-10-Oxid und ein DOPO enthaltendes Novolakharz oder eine Mischung von mindestens zwei davon umfasst.

5. Wärmehärtbare Harzzusammensetzung nach Anspruch 1, **dadurch gekennzeichnet, dass** der Härtungsbeschleuniger ein beliebiger ist, der aus der Gruppe ausgewählt worden ist, die ein Imidazol, Metallsalze, tertiäre Amine oder Piperidinverbindungen oder eine Mischung von mindestens zwei davon umfasst,
wobei bevorzugt der Härtungsbeschleuniger ein beliebiger ist, der aus der aus der Gruppe ausgewählt worden ist, die ein 2-Methylimidazol, ein Undecylimidazol, ein 2-Ethyl-4-Methylimidazol, ein 2-Phenylimidazol, ein mit 1-Cyanoethyl substituiertes Imidazol, ein Benzyldimethylamin, ein Cobaltacetylacetonat, ein Kupferacetylacetonat und ein Zinkisoctanoat oder eine Mischung von mindestens zwei davon umfasst.

6. Wärmehärtbare Harzzusammensetzung nach Anspruch 1, **dadurch gekennzeichnet, dass** der Füllstoff ein anorganischer oder ein organischer Füllstoff ist,
wobei bevorzugt der Füllstoff ein anorganischer Füllstoff ist, der aus der Gruppe ausgewählt worden ist, die ein Aluminiumhydroxid, ein Aluminiumoxid, ein Magnesiumhydroxid, ein Magnesiumoxid, ein Aluminiumoxid, ein Siliziumdioxid, ein Calciumcarbonat, ein Aluminiumnitrid, ein Bornitrid, ein Siliziumcarbid, ein Titandioxid, ein Zinkoxid, ein Zirkoniumoxid, einen Glimmer, ein Böhmit, einen kalzinierten Talk, ein Talkpulver, ein Siliziumnitrid und ein kalziniertes Kaolin oder eine Mischung von mindestens zwei davon umfasst,
wobei bevorzugt der Füllstoff ein organischer Füllstoff ist, der aus der Gruppe ausgewählt worden ist, die ein Polytetrafluorethylenpulver, ein Polyphenylensulfid und ein Polyethersulfonpulver oder eine Mischung von mindestens zwei davon umfasst.

7. Vorimprägnierter Werkstoff, der aus der wärmehärtbaren Harzzusammensetzung nach einem der Ansprüche 1 bis 6 hergestellt worden ist, **dadurch gekennzeichnet, dass** der vorimprägnierte Werkstoff ein Matrixmaterial aufweist, und dass die wärmehärtbare Harzzusammensetzung darauf nach einem Imprägnieren und einem Trocknen angebracht worden ist,
wobei bevorzugt das Matrixmaterial ein nicht gewebtes oder ein gewebtes Glasfasergewebe ist.

8. Laminat, das den vorimprägnierten Werkstoff nach Anspruch 7 aufweist.

9. Leiterplatte, die das Laminat nach Anspruch 8 aufweist.

## Revendications

1. Composition de résine thermodurcissable constituée des composants suivants en partie en poids : 50-150 parties d'un cyanate, 30-120 parties d'une résine époxy, 20-70 parties d'allylbenzène-anhydride maléique, 20-100 parties d'un polyphényléther, 30-100 parties d'un ignifugeant sans halogène, 0,05-5 parties d'un accélérateur de durcissement, et 50-200 parties d'une charge ;
l'allylbenzène-anhydride maléique a la formule structurale chimique suivante : 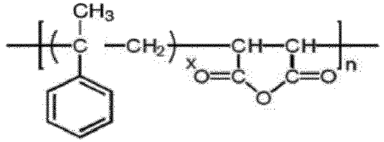 où x est 1-4, 6 et 8 ; n est 1-12 ; x et n sont tous deux des nombres entiers.

2. Composition de résine thermodurcissable revendiquée dans la revendication 1, **caractérisée en ce que** le cyanate est au moins l'un choisi dans le groupe constitué par les suivants 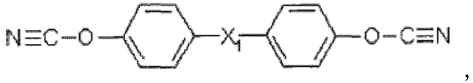 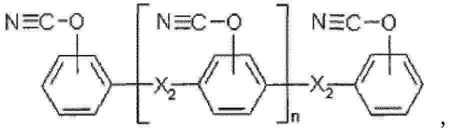 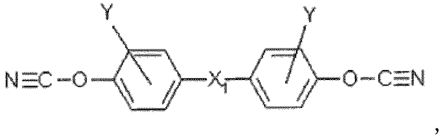 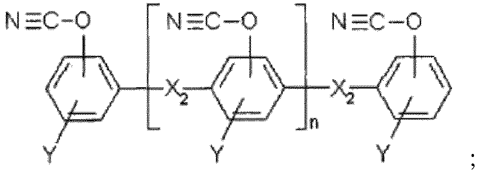 où X₁ et X₂ sont chacun indépendamment choisis parmi au moins l'un de R, Ar, SO₂ et O; R est choisi dans le groupe constitué par -C(CH₃)₂-, -CH(CH₃)₂-, -CH₂- et un dicyclopentadiényle substitué ou non substitué ; Ar est l'un quelconque choisi dans le groupe constitué par le benzène substitué ou non substitué, le biphényle, le naphtalène, l'aldéhyde phénolique, le bisphénol A, l'aldéhyde phénolique de bisphénol A, le bisphénol F et l'aldéhyde phénolique de bisphénol F ; n est un nombre entier supérieur ou égal à 1 ; Y est un groupe fonctionnel aliphatique ou un groupe fonctionnel aromatique.

3. Composition de résine thermodurcissable revendiquée dans la revendication 1, **caractérisée en ce que** la résine époxy est l'une quelconque choisie dans le groupe constitué par une résine époxy de type bisphénol A, une résine époxy de type bisphénol F, une résine époxy de type bisphénol AD, une résine époxy de type bisphénol Z, une résine époxy de type bisphénol M, une résine époxy de type bisphénol AP, une résine époxy de type bisphénol TMC, une résine époxy biphényle, une résine époxy novolaque de type alkyle, une résine époxy dicyclopentadiène, une résine époxy novolaque de type bisphénol A, une résine époxy novolaque de type o-crésol, une résine époxy novolaque de type phénol, une résine époxy trifonctionnelle, une résine époxy tétrafonctionnelle, une résine époxy modifiée par un isocyanate et une résine époxy de type naphtalène, ou un mélange d'au moins deux choisies parmi celles-ci.

4. Composition de résine thermodurcissable revendiquée dans la revendication 1, **caractérisée en ce que** l'ignifugeant sans halogène est l'un quelconque choisi dans le groupe constitué par le phosphazène, le polyphosphate d'ammonium, la tri-(2-carboxyéthyl)phosphine, le tri-(isopropylchloro)phosphate, le phosphate de triméthyle, le phosphate de diméthyl-méthyle, le phosphate de résorcinol bis-xylyle, les composés phospho-azotés, le polyphosphate de mélamine, le cyanurate de mélamine, l'isocyanurate de tri-hydroxyéthyle, le 9,10-dihydro-9-oxa-10-phosphaphénanthrène-10-oxyde et la résine novolaque contenant DOPO, ou un mélange d'au moins deux choisis parmi ceux-ci.

5. Composition de résine thermodurcissable revendiquée dans la revendication 1, **caractérisée en ce que** l'accélérateur de durcissement est l'un quelconque choisi dans le groupe constitué par l'imidazole, les sels métalliques, les amines tertiaires ou les composés de pipéridine, ou un mélange d'au moins deux choisis parmi ceux-ci ;
de préférence, l'accélérateur de durcissement est l'un quelconque choisi dans le groupe constitué par le 2-méthylimidazole, l'undécylimidazole, le 2-éthyl-4-méthylimidazole, le 2-phényl-imidazole, l'imidazole substitué par un 1-cyanoéthyle, la benzyldiméthylamine, l'acétylacétonate de cobalt, l'acétylacétonate de cuivre et l'acétylacétonate de zinc, ou un mélange d'au moins deux choisis parmi ceux-ci.

6. Composition de résine thermodurcissable revendiquée dans la revendication 1, **caractérisée en ce que** la charge est une charge inorganique ou organique ;
de préférence, la charge est une charge inorganique, qui est l'une quelconque choisie dans le groupe constitué par l'hydroxyde d'aluminium, l'alumine, l'hydroxyde de magnésium, l'oxyde de magnésium, l'oxyde d'aluminium, le dioxyde de silicium, le carbonate de calcium, le nitrure d'aluminium, le nitrure de bore, le carbure de silicium, le dioxyde de titane, l'oxyde de zinc, l'oxyde de zirconium, le mica, la boehmite, le talc calciné, la poudre de talc, le nitrure de silicium et le kaolin calciné, ou un mélange d'au moins deux choisis parmi ceux-ci ;
de préférence, la charge est une charge organique, qui est l'une quelconque choisie dans le groupe constitué par la poudre de polytétrafluoroéthylène, le polysulfure de phénylène et la poudre de polyéthersulfone, ou un mélange d'au moins deux choisis parmi ceux-ci.

7. Pré-imprégné préparé à partir de la composition de résine thermodurcissable revendiquée dans l'une quelconque des revendications 1 à 6, **caractérisé en ce que** le pré-imprégné comprend un matériau de matrice, et la composition de résine thermodurcissable liée sur celui-ci après imprégnation et séchage ;
de préférence, le matériau de matrice est un produit de fibre de verre non tissé ou tissé.

8. Stratifié comprenant le pré-imprégné revendiqué dans la revendication 7.

9. Carte de circuit imprimé comprenant le stratifié revendiqué dans la revendication 8.
